# FASCICULE DE BREVET EUROPEEN

(11) **EP 4 305 392 B1**
(45) Date de publication et mention de la délivrance du brevet: **28.01.2026**
(21) Numéro de dépôt: 22710648.1
(22) Date de dépôt: 16.02.2022
(51) Int. Cl.: G01J 5/06

(54) **SYSTEME DE COMMANDE POUR ECRAN DE BLINDAGE ACTIF**
STEUERSYSTEM FÜR EINEN AKTIVEN SCHIRM
CONTROL SYSTEM FOR AN ACTIVE SHIELDING SCREEN

(30) Priorité: 11.03.2021 FR 2102339
(43) Date de publication de la demande: 17.01.2024
(73) Titulaire: Centre National de la Recherche Scientifique, 75794 Paris Cedex 16 (FR); Université de Rennes, 35065 Rennes Cedex (FR); Safran Electronics & Defense, 75015 Paris (FR)
(72) Inventeur: TRICAS, Quentin, 77550 MOISSY-CRAMAYEL (FR); FOUTREL, Patrice, 77550 MOISSY-CRAMAYEL (FR); BESNIER, Philippe, 75016 PARIS (FR); CASTEL, Xavier, 35000 RENNES (FR); LE PAVEN, Claire, 35000 RENNES (FR)
(74) Mandataire: Ernest Gutmann - Yves Plasseraud S.A.S.
(86) Numéro de dépôt international: PCT/FR2022/050284
(87) Numéro de publication internationale: WO 2022/189717

(56) Documents cités:
- WO-A1-2018/215243
- US-A1- 2011 115 686
- TÉLÉDÉTECTION DE: "Notions fondamentales", 3 August 2007 (2007-08-03), pages 1 - 266, XP055863166, Retrieved from the Internet <URL:https://www.rncan.gc.ca/sites/www.nrcan.gc.ca/files/earthsciences/pdf/resource/tutor/fundam/pdf/fundamentals_f.pdf> [retrieved on 20211118]
- INFINEON: "RF and microwave power detection with Schottky diodes", 31 July 2018 (2018-07-31), XP055863236, Retrieved from the Internet <URL:https://www.infineon.com/dgdl/Infineon-AN_1807_PL32_1808_132434_RF%20and%20microwave%20power%20detection%20-AN-v01_00-EN.pdf?fileId=5546d46265f064ff0166440727be1055> [retrieved on 20211118]
- TAKACS A ET AL: "Ultra-compact Ku band rectenna", 2015 IEEE MTT-S INTERNATIONAL MICROWAVE SYMPOSIUM, IEEE, 17 May 2015 (2015-05-17), pages 1 - 4, XP033181448, DOI: 10.1109/MWSYM.2015.7166996

## Description

### Domaine technique

La présente description se situe dans le domaine des blindages électromagnétiques actifs pourvus d'un traitement de protection contre les ondes électromagnétiques pour hublots et optiques utilisables sur des équipements optroniques. Elle propose un système de commande de l'activation/désactivation d'un écran de blindage électromagnétique directement piloté par la détection d'un rayonnement électromagnétique à atténuer.

### Technique antérieure

Les systèmes optiques de détection sont généralement placés derrière des hublots ou des fenêtres de protection. Il est nécessaire de protéger des dispositifs de vision optiques tels que des capteurs optiques de détection et leurs circuits électroniques, par exemple des capteurs sensibles à des rayonnements optiques qui appartiennent au domaine visible et/ou infrarouge dont le fonctionnement peut être perturbés par des rayonnements électromagnétiques, notamment du domaine hyperfréquence.

En effet, les rayonnements hyperfréquences peuvent interagir avec des circuits électroniques qui doivent être placés à proximité immédiate des capteurs et qui ne peuvent être déportés dans des volumes protégés contre les rayonnements hyperfréquences provenant de l'extérieur.

Il est connu de disposer sur le hublot ou la fenêtre, devant un capteur optique, un élément de blindage qui est au moins partiellement opaque pour une partie des rayonnements hyperfréquences, tout en étant au moins partiellement transparent pour les rayonnements optiques. Pour cela, l'élément de blindage comporte en général au moins une structure bidimensionnelle telle qu'un maillage de pistes métalliques qui est conductrice électriquement dans le domaine fréquentiel des hyperfréquences, en étant au moins partiellement transparente pour les rayonnements optiques.

Pour procurer une protection efficace contre les rayonnements hyperfréquences, la structure bidimensionnelle formant le blindage conducteur dans le domaine des hyperfréquences doit en outre être relié électriquement à une partie au moins d'une coque qui est aussi conductrice électriquement, et qui entoure le (les) capteur(s) à protéger. Cette coque peut elle-même être reliée électriquement à la masse électrique d'un support ou d'un véhicule porteur sur lequel le ou les capteurs optiques sont installés, ou bien connectés à une référence électrique. Toutes ces connexions doivent présenter une faible impédance électrique dans le domaine des hyperfréquences pour procurer la protection voulue.

Toutefois il est dans certains cas souhaité de pouvoir inclure avec les systèmes de capteurs optiques, des systèmes de capteurs de rayonnement hyperfréquence qui nécessitent que le blindage reste transparent aux hyperfréquences dans une gamme d'énergie électromagnétique donnée tout en produisant une efficacité de blindage suffisante pour des niveaux d'énergie supérieurs.

Ceci est aussi nécessaire lorsque le système à protéger émet lui-même un rayonnement hyperfréquence qui est susceptible de perturber son propre fonctionnement si ces rayonnements ne peuvent pas se propager vers l'extérieur.

Il est alors connu de réaliser des blindages adaptatifs dont l'efficacité est augmentée en présence de rayonnements hyperfréquences de forte énergie électromagnétique.

Le document WO2018/215243 propose notamment un écran de blindage à maillage métallique micrométrique directement imprimé sur les faces internes d'optiques ou de hublots de différents équipements optroniques. Ce maillage métallique micrométrique est défini par la largeur de ses rubans métalliques constitutifs, son pas de maillage ou période et l'épaisseur de métallisation utilisée. La modulation de l'efficacité de blindage pour son passage de l'état actif (état ON) à l'état inactif (état OFF) et réciproquement est obtenue par un contrôle de la valeur de la résistance électrique de contact entre le maillage métallique et le retour de masse de l'écran de blindage. Ce contrôle est réalisé, soit par l'implantation de composants électroniques localisés (diodes PIN, MEMS, NEMS, etc.) entre le maillage métallique micrométrique et le retour de masse ; soit par l'utilisation de rubans imprimés à base de matériaux à transition métal/isolant qui sont typiquement des matériaux thermoactivables et électroactivables. Ces dispositifs comportent un état conducteur électrique (état ON) et un état isolant (état OFF) ou modulent la valeur de la résistance de contact, et en conséquence, la valeur de l'efficacité de blindage de l'écran, et ce de manière totalement réversible.

### Problème technique

Dans les dispositifs actuels, le passage de l'écran de blindage de l'état OFF à l'état ON et réciproquement est réalisé via l'action d'un opérateur humain et une source d'énergie externe. L'opérateur peut, par exemple, couper ou imposer la circulation du courant DC alimentant les composants électroniques de commande du blindage. Or il est des situations où l'on souhaite que le blindage puisse passer automatiquement d'un état transparent à un état bloquant pour les ondes électromagnétiques, en particulier hyperfréquences.

### Résumé

Un objectif de la présente invention est de fournir des ensembles de blindage qui soient adaptés à passer automatiquement d'un mode inactif à un mode actif et réciproquement selon l'intensité d'un rayonnement hyperfréquence pour répondre à des situations dans lesquelles le rayonnement hyperfréquence devient trop important ou reste compatible avec une mesure de rayonnement.

Pour ce faire la présente invention propose un système de commande de l'activation/désactivation d'un écran de blindage électromagnétique pourvu d'un dispositif d'activation/désactivation pour un hublot ou d'une fenêtre de protection d'un équipement optoélectronique, qui comporte, un capteur électromagnétique de réception de champ électromagnétique radiofréquence, de bande passante adaptée à une bande de coupure dudit écran de blindage correspondant à une plage de champs électromagnétiques à bloquer, relié à un détecteur-redresseur de sensibilité supérieure à une valeur minimale de la puissance d'un champs électromagnétique à bloquer au moyen dudit écran de blindage électromagnétique, lesdits capteur électromagnétique et détecteur-redresseur étant configurés pour, en présence du champs électromagnétique de puissance dépassant ladite valeur minimale, activer ledit dispositif d'activation/désactivation de l'écran de blindage électromagnétique en captant l'énergie électromagnétique fournie par ledit champs électromagnétique de puissance dépassant ladite valeur minimale.

L'invention met ainsi à profit l'énergie du champs électromagnétique incident pour piloter l'écran de blindage adaptatif.

Le dispositif d'activation/désactivation étant un dispositif à diodes PIN (de l'anglais Positive Intrinsic Negative diode), ledit détecteur-redresseur peut fournir directement, à partir de l'énergie électromagnétique du signal de sortie dudit détecteur-redresseur une tension ou un courant d'alimentation du dispositif à diodes pin nécessaire à activer ledit écran de blindage électromagnétique.

Dans cette configuration, aucune alimentation électrique du système n'est nécessaire.

Le capteur électromagnétique radiofréquence peut être une antenne dimensionnée pour capter une énergie électromagnétique adaptée à permettre audit dispositif détecteur-redresseur de produire directement une tension ou un courant d'alimentation dudit dispositif d'activation/désactivation nécessaire à activer ledit blindage pour une valeur de puissance de champs électromagnétique à bloquer supérieure à une valeur de consigne. Le dimensionnement de l'antenne va alors réaliser une fonction de seuil de mise en fonctionnement du blindage.

L'écran de blindage peut être relié à une structure collectrice, notamment un encadrement électriquement conducteur du blindage relié à la masse, au travers d'un réseau comportant une pluralité de liaisons parallèles, chaque liaison comportant un condensateur et une diode PIN en série, le détecteur-redresseur réalisant, en présence dudit champs électromagnétique de puissance dépassant ladite valeur minimale, une source de tension continue de polarisation électrique desdites diodes PIN connectée aux anodes des diodes PIN au travers de résistances, les cathodes desdites diodes PIN étant connectées à la structure collectrice.

Le dispositif d'activation/désactivation peut être un dispositif à diodes PIN entre l'écran de blindage et un cadre de l'écran de blindage ou un réseau à pistes en matériaux à transition isolant/métal, par exemple VO₂, ou un système à pompe d'injection d'un liquide à haute permittivité diélectrique et/ou conducteur électriquement au sein d'un canal périphérique entre la structure de l'écran de blindage électromagnétique et son encadrement relié à la masse, qui peut comporter dans ce cas un étage d'amplification intercalé entre le dispositif détecteur-redresseur et ledit dispositif à diodes PIN, ledit réseau à pistes de matériaux à transition isolant/métal ou ledit système à pompe dudit écran de blindage électromagnétique. Ceci permet de piloter/d'activer des dispositifs nécessitant une plus grande puissance d'alimentation électrique Ou activer les dispositifs avec une onde incidente de plus faible puissance.

Selon un mode de réalisation particulier, un comparateur peut être disposé en sortie du détecteur-redresseur pour piloter ledit amplificateur ce qui permet de définir un seuil d'activation.

Le ou les étages d'amplification peuvent être alimenté par une source de tension ou de courant externe audit équipement optoélectronique ou être alimentés par une source de courant.

Le signal électromagnétique incident étant un signal modulé en impulsion, le détecteur-redresseur peut être configuré pour avoir une constante de temps de décroissance du signal de détection supérieure à l'inverse d'une fréquence de répétition du signal électromagnétique incident en sorte de maintenir le signal de commande actif entre les répétitions dudit signal électromagnétique.

Le détecteur-redresseur peut comporter ou être constitué d'un détecteur RF à diode Schottky.

L'invention s'applique à un écran de blindage actif, pour hublot ou fenêtre de protection d'un équipement électronique, comportant une structure bidimensionnelle conductrice électriquement dans le domaine fréquentiel des hyperfréquences, en étant au moins partiellement transparente aux rayonnements optiques et comportant un dispositif d'activation/désactivation adapté à activer ledit blindage en reliant ladite structure à une masse électrique d'un support, qui comporte un système de commande selon l'invention.

### Brève description des dessins

D'autres caractéristiques, détails et avantages apparaîtront à la lecture de la description détaillée ci-après, et à l'analyse des dessins annexés, sur lesquels :
[Fig. 1] montre un schéma de principe de pilotage d'un écran de blindage adaptatif à maillage commandé par diodes PIN ;
[Fig. 2] montre un schéma de principe de pilotage d'un écran de blindage adaptatif à polarisation de maillage ;
[Fig. 3] montre un schéma de principe de pilotage d'un écran de blindage adaptatif à rubans imprimés à base de matériaux à transition métal/isolant, par exemple VO₂ ;
[Fig. 4] montre un schéma de principe de pilotage d'un écran de blindage adaptatif à pompe microfluidique.

### Description des modes de réalisation

La présente invention concerne les écrans de blindage actifs, passant d'un état électromagnétiquement transparent (état OFF) à un état d'atténuation ou blocage (état ON) de manière autonome, sans intervention aucune d'une action humaine, et ce dès l'apparition d'un champs électromagnétique hyperfréquence d'intensité supérieure à une valeur limite dans une bande de fréquences à atténuer, rendant ainsi l'écran de blindage «intelligent». Les champs électromagnétiques concernés par l'invention sont des champs électromagnétiques par exemple de fréquence comprise entre 0,1 GHz (gigahertz) et 40 GHz et notamment générés par des signaux hyperfréquences modulés en impulsion.

De tels écrans de blindage ou blindages comportent un maillage métallique 11a, 11b, 11c, 11d tel qu'un maillage métallique à pas micrométrique imprimé sur un substrat électromagnétiquement et optiquement transparent d'un hublot ou d'une fenêtre, qui lorsque le blindage est activé va être relié à la masse par exemple au travers d'un cadre électriquement conducteur lui-même à la masse.

Le dispositif objet de l'invention a pour base un capteur électromagnétique radiofréquence RF 1, qui peut être situé hors de la zone protégée par le blindage électromagnétique. Ce capteur, dont la bande passante est adaptée à la contrainte électromagnétique est associé à un détecteur dont la constante de temps est également adaptée à la forme d'onde du signal incident qui est le plus souvent modulé en impulsion. Le détecteur fait office de redresseur, lui-même relié si besoin à un amplificateur électronique. Le tout est relié au dispositif de mise à la masse du blindage.

En phase de contrainte électromagnétique, le capteur RF est sensible à cette contrainte et un courant RF est généré en son sein. Le courant RF est ensuite détecté et transformé en courant continu par le détecteur-redresseur. Si l'énergie de la contrainte électromagnétique est suffisamment élevée pour activer le dispositif de variation de l'efficacité de blindage de l'écran de blindage, aucune source d'alimentation supplémentaire à l'énergie du signa incident ne doit être fournie au système, au moyen par exemple d'un dispositif d'amplification du signal. Dans le cas contraire, il sera associé au dispositif à protéger.

Les modes de réalisation des dispositifs décrits ci-dessous mettent en oeuvre un écran de blindage dont l'efficacité de blindage (EB) peut être modifiée automatiquement de façon réversible selon deux états : Etat ON pour lequel l'efficacité de blindage est maximale lorsque l'équipement est soumis à une contrainte électromagnétique externe ; Etat OFF pour lequel l'efficacité de blindage est minimale lorsque l'équipement est hors contrainte électromagnétique. Cet écran doit de plus conserver à tout instant une transparence optique optimale par exemple dans les domaines de l'UV, du visible et de l'IR, en accord avec les spectres de fonctionnement des différents capteurs dont il assure la protection. Par ailleurs, hors phase de contrainte EM, une forte efficacité de blindage est superflue car (1) elle limite les pouvoirs de détection des capteurs d'ondes électromagnétiques et (2) elle peut même perturber le bon fonctionnement de l'ensemble des capteurs par un phénomène d'auto-perturbation du système lorsque les ondes électromagnétiques générées par ledit système restent confinées au sein de la structure ou du véhicule porteur.

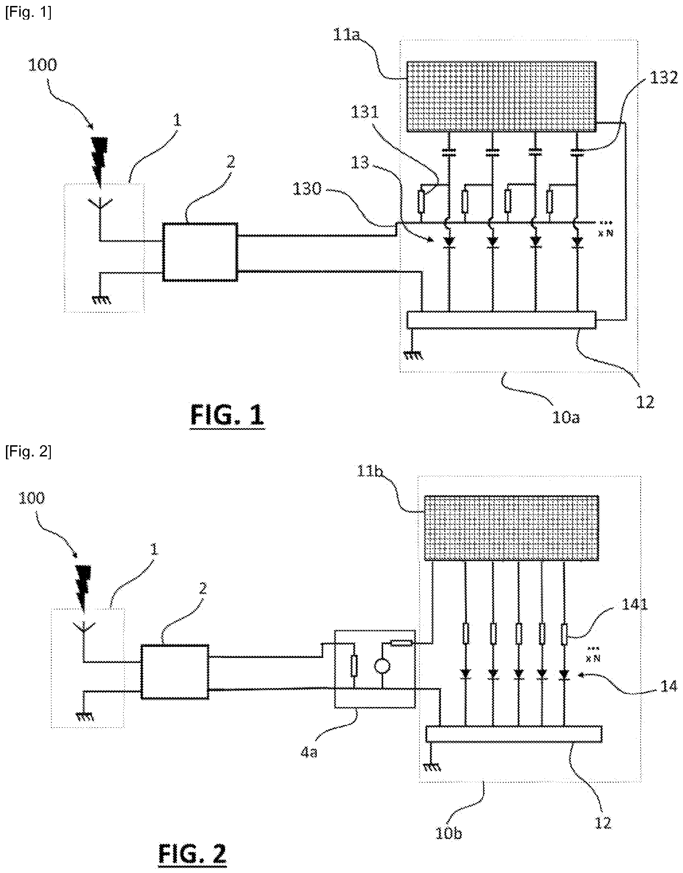

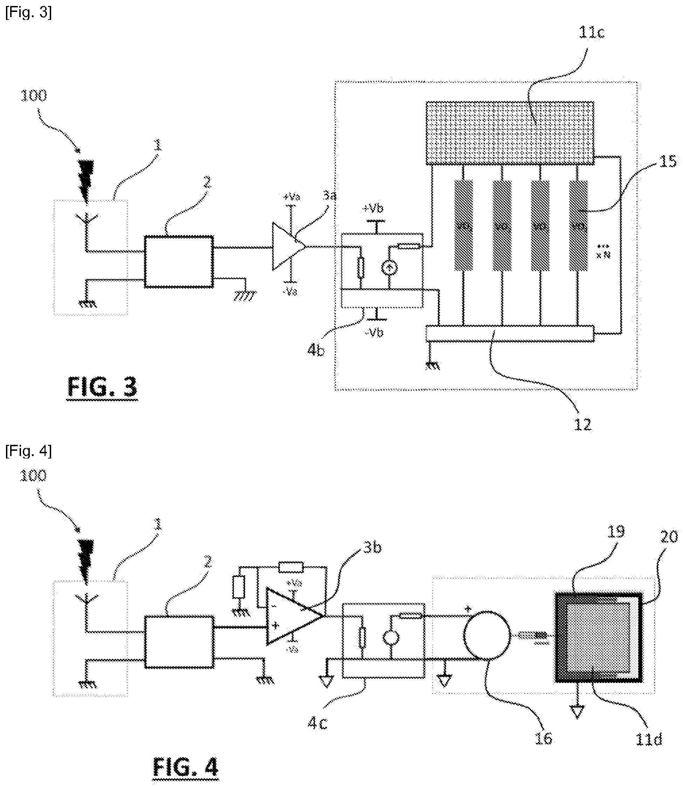

Selon les figures 1 à 4, les dispositifs d'alimentation de blindages électromagnétiques sont :
des pistes conductrices ramenées à la masse au travers des diodes PIN polarisées dans le cas de la figure 1 ;
une polarisation du maillage et un réseau de diodes PIN de retour à la masse dans le cas de la figure 2 ;
un système d'alimentation électrique ou thermique de commutation d'un matériau à transition métal/isolant, par exemple VO₂ selon la figure 3 ;
un système d'alimentation électrique 16 d'une ou plusieurs pompes en figure 4.

Le dispositif de détection de l'onde électromagnétique à bloquer comporte un détecteur basé sur un capteur électromagnétique radiofréquence RF 1, qui peut être situé hors de la zone protégée par l'écran de blindage électromagnétique. Ce capteur, qui se comporte comme une antenne, a une bande passante adaptée à la contrainte électromagnétique à laquelle le système ou véhicule porteur équipé de capteurs à protéger va être exposé. Ce capteur est associé à un détecteur-redresseur 2 dont la constante de temps est également adaptée à la forme d'onde du signal incident le plus souvent modulé en impulsion.

En phase de contrainte électromagnétique, le capteur RF est sensible à cette contrainte et un courant RF est généré en son sein. Le courant RF est ensuite détecté et transformé en courant DC par le détecteur-redresseur 2 par exemple un détecteur-redresseur à diode Schottky en fonction de la puissance reçue.

Plusieurs configurations sont possibles en fonction de l'énergie de la perturbation électromagnétique 100 que l'on souhaite atténuer ou de la tension nécessaire pour activer le dispositif de commande et/ou d'alimentation de l'écran de blindage adaptatif 11a, 11b, 11c, 11d.

Pour le cas de la figure 1, l'écran de blindage 11a est relié à une structure collectrice 12, par exemple un encadrement électriquement conducteur du blindage relié à la masse, au travers d'un réseau comportant une pluralité de liaisons parallèles, chaque liaison comportant un condensateur 132 et une diode PIN 13. Le détecteur-redresseur 2 réalise une source de tension continue connectée aux anodes des diodes PIN 13 au travers de résistances 131 pour polariser électriquement ces diodes dont les cathodes sont connectées à la structure collectrice. Cette polarisation permet la conduction des diodes PIN 13, qui est effective pour un courant alternatif à une fréquence comprise entre 0,1 GHz et 40 GHz, dit courant hyperfréquence. Le courant hyperfréquence qui circule à travers les diodes 13 est généré par le rayonnement hyperfréquence 100 qui est incident sur la grille 11a de la structure bidimensionnelle de blindage. Pour réaliser un filtre passe haut, des condensateurs de découplage 132 sont insérés entre l'écran 11a et les anodes des diodes PIN 13.

Lorsque la commande de l'écran de blindage adaptatif consiste en une polarisation comme dans le cas de la figure 1, la sortie du détecteur-redresseur est directement relié au réseau de diodes PIN 13 à polariser au travers de résistances 131. Dans ce cas, les diodes devenues passantes, l'énergie de l'onde électromagnétique haute fréquence reçue par l'écran de blindage 11a est évacuée au travers des condensateurs 132 et des diodes PIN 13 vers l'encadrement 12 mis à la masse. Ce système passif évite d'avoir besoin d'une alimentation électrique pour l'écran de blindage et le dispositif de détection.

Par exemple, pour se passer d'étage d'amplification dans un tel cas, en utilisant une antenne et un détecteur RF de type 33330C de la société Keysight dont l'impédance de sortie est de l'ordre de 1,3 KOhm, pour alimenter un réseau de diodes PIN, il faut générer a minima une différence de potentiel en DC de l'ordre de 13 Volt pour générer un courant de 10 mA afin de polariser les diodes PIN. Pour ce faire, l'antenne en réception doit collecter 26 mW (idéalement 10 mW) sachant que le détecteur délivre 0,5 mV DC par microwatt de puissance RF. Ceci correspond approximativement à un champs incident de l'ordre de 1000 V/m (pour une antenne de réception isotrope). C'est typiquement l'ordre de grandeur de certaines situations opérationnelles connues en termes de normalisation sous le vocable « High Intensity Radiated field » en anglais.

Le système mis au point peut toutefois évoluer et n'est ici qu'un exemple (le choix d'autres détecteurs ou la réalisation de détecteur approprié est possible par exemple)

Le cas de la figure 2 est un cas où la polarisation des diodes PIN 14 se fait directement au moyen d'une polarisation de l'écran de blindage. Dans cet exemple, un amplificateur 4a est intercalé entre le détecteur-redresseur et l'écran de blindage et cet amplificateur comporte une alimentation qui peut être située hors de la zone à protéger.

Il est à noter toutefois que si l'énergie de la contrainte EM est suffisamment élevée pour activer le dispositif de variation de l'EB de l'écran de blindage directement au moyen du courant issu du détecteur-redresseur, l'amplificateur peut ne pas être nécessaire comme pour le cas de la figure 1.

L'activation automatique du dispositif de contrôle de l'efficacité de blindage de l'écran de blindage par la conversion de la puissance de l'onde électromagnétique incidente ou de l'énergie dans le cas d'une impulsion répétée, permet d'accroître l'efficacité de blindage dudit écran de blindage (état ON).

Dans le cas de la figure 3, l'énergie de la contrainte EM captée par l'antenne est utilisée dans le cadre d'une solution à pistes de matériaux à transition isolant/métal, par exemple VO₂. Le dispositif de détection sert à générer une différence de potentiel au bord des pistes en VO₂ dans le but de provoquer la transition isolant/métal du matériau reliant le maillage 11c à son pourtour de masse électrique 12. Cela diminue l'impédance de contact entre le maillage et le pourtour, augmentant ainsi l'efficacité de blindage de l'écran de blindage adaptatif. Une solution alternative est d'utiliser le dispositif de détection pour alimenter un dispositif de chauffage localisé au niveau des pistes de VO₂, dans le but de provoquer la transition isolant/métal du matériau reliant le maillage à son pourtour.

Cette solution peut, comme représenté, nécessiter un étage d'amplification 3a qui sera alimenté par une source électrique intrinsèque pouvant se situer en dehors de la zone à protéger et par un étage d'amplification de puissance 4b pouvant lui comporter une alimentation située dans la zone à protéger par le blindage. Une isolation galvanique peut aussi être prévue entre les composants situés hors de la zone protégée par le blindage et les composants situés dans la zone protégée par le blindage. De même un filtrage CEM peut aussi être prévu en entrée de la zone protégée.

La figure 4 correspond à un dispositif de blindage adaptatif utilisant une ou plusieurs pompes 16 injectant un liquide à haute permittivité diélectrique 19 et/ou conducteur électriquement au sein d'un canal périphérique 19 entre la structure de blindage électromagnétique 11d et son encadrement relié à la masse ce qui diminue l'impédance de contact entre le maillage et l'encadrement, augmentant ainsi l'efficacité de blindage de l'écran de blindage. L'énergie de la contrainte électromagnétique captée par l'antenne va alimenter électriquement la ou les pompes 16 au travers d'un amplificateur 4c de puissance électrique suffisante. Dans cet exemple, un comparateur 3b avec un seuil prédéfini va permettre de choisir le niveau d'énergie électromagnétique à partir duquel on souhaite mettre en fonction le blindage adaptatif. Ici aussi, une isolation galvanique peut aussi être prévue entre les composants situés hors de la zone non protégée par le blindage et les composants situés dans la zone protégée par le blindage.

Pour les solutions basées sur les composants électroniques ou un matériau à transition métal/isolant, par exemple VO₂, l'arrêt de la contrainte électromagnétique conduit à l'arrêt de l'alimentation du dispositif de contrôle de l'efficacité de blindage : les diodes redeviennent bloquantes, ou le matériau VO₂ redevient isolant électriquement et donc une diminution automatique de l'efficacité de blindage de l'écran de blindage est obtenue.

Pour le système à pompe, une purge du liquide à haute permittivité diélectrique et/ou conducteur électriquement au travers de son aspiration via une dépression, ou bien par son expulsion au travers de l'injection d'un gaz sous pression doit être réalisée.

Le dispositif de l'invention adapté plus particulièrement à la protection de systèmes dans le cas de champs forts de plusieurs centaines de V/m et aux champs pulsés par exemple, avec par exemple des trains d'impulsions de l'ordre d'une dizaine à plusieurs centaine de nanosecondes se répétant avec une période de l'ordre de la microseconde, joue ainsi un triple rôle : détection de la contrainte EM ; générateur de puissance électrique du dispositif de protection ; activation du dispositif de variation de l'EB de l'écran de blindage.

Le dispositif de l'invention en captant l'énergie électromagnétique fournie par un champs électromagnétique intense peut ainsi activer automatiquement l'état ON de l'écran de blindage, rendant ainsi l'écran de blindage indépendant de toute source d'énergie externe ou permettant de réduire les besoins en énergie externe. Un tel contrôle auto-adaptatif permet également le retour à l'état OFF dès que la contrainte électromagnétique n'est plus détectée pour les dispositifs à diode PIN ou matériau à transition métal/isolant.

L'activation automatique du dispositif de contrôle de l'efficacité de blindage de l'écran de blindage par la conversion de l'énergie de l'onde électromagnétique incidente permet d'accroître l'efficacité de blindage dudit écran de blindage (état ON).

## Revendications

1. Système de commande de l'activation/désactivation d'un écran de blindage électromagnétique (11a, 11b, 11c, 11d) pourvu d'un dispositif (13, 14, 15, 16) d'activation/désactivation pour un hublot ou d'une fenêtre de protection d'un équipement optoélectronique, **caractérisé en ce qu'**il comporte, un capteur électromagnétique de réception de champ électromagnétique radiofréquence (1), de bande passante adaptée à une bande de coupure dudit écran de blindage correspondant à une plage de champs électromagnétiques à bloquer, relié à un détecteur-redresseur (2) de sensibilité supérieure à une valeur minimale de la puissance d'un champ électromagnétique à bloquer au moyen dudit écran de blindage électromagnétique, lesdits capteur électromagnétique et détecteur-redresseur étant configurés pour, en présence du champ électromagnétique de puissance dépassant ladite valeur minimale, capter l'énergie électromagnétique fournie par ledit champ électromagnétique de puissance pour alimenter et activer ledit dispositif (13, 14, 15, 16) d'activation/désactivation de l'écran de blindage électromagnétique au moyen de l'énergie électromagnétique fournie par ledit champ électromagnétique de puissance dépassant ladite valeur minimale.

2. Système de commande selon la revendication 1, pour lequel, le dispositif d'activation/désactivation étant un dispositif à diodes PIN (13, 14), ledit détecteur-redresseur (2) convertit l'énergie électromagnétique du signal capté par ledit détecteur-redresseur (2) en une tension ou un courant d'alimentation du dispositif à diodes PIN nécessaire à activer ledit écran de blindage électromagnétique.

3. Système de commande selon la revendication 2, pour lequel le capteur électromagnétique radiofréquence est une antenne (1) dimensionnée pour capter une énergie électromagnétique adaptée à permettre audit dispositif détecteur-redresseur de produire directement une tension ou un courant d'alimentation dudit dispositif d'activation/désactivation nécessaire à activer ledit blindage pour une valeur de puissance de champ électromagnétique à bloquer supérieure à une valeur de consigne.

4. Système de commande selon la revendication 2 ou 3, pour lequel, l'écran de blindage (11a) est relié à une structure collectrice (12) au travers d'un réseau comportant une pluralité de liaisons parallèles, chaque liaison comportant un condensateur (132) et une diode PIN (13) en série, le détecteur-redresseur (2) réalisant, en présence dudit champ électromagnétique de puissance dépassant ladite valeur minimale, une source de tension continue de polarisation électrique desdites diodes PIN connectée aux anodes des diodes PIN (13) au travers de résistances (131), les cathodes desdites diodes PIN étant connectées à la structure collectrice.

5. Système de commande selon la revendication 4, pour lequel la structure collectrice (12) est un encadrement électriquement conducteur du blindage relié à une masse dudit équipement.

6. Système de commande selon la revendication 1, pour lequel, le dispositif d'activation/désactivation est un dispositif à diodes PIN entre l'écran de blindage et un cadre (12) de l'écran de blindage ou un réseau à pistes de matériaux à transition isolant/métal, par exemple VO₂ (15) ou un système à pompe (16) d'injection d'un liquide à haute permittivité diélectrique et/ou conducteur électriquement au sein d'un canal périphérique (19) entre la structure de l'écran de blindage électromagnétique (11d) et son encadrement relié à la masse, et comporte un étage d'amplification (4a, 4b, 4c) intercalé entre le dispositif détecteur/redresseur et ledit dispositif à diodes PIN, ledit réseau à pistes de matériaux à transition isolant/métal ou ledit système à pompe (16) dudit écran de blindage électromagnétique.

7. Système de commande selon la revendication 6 pour lequel un comparateur (3b) en sortie du détecteur-redresseur pilote ledit amplificateur.

8. Système de commande selon la revendication 6 ou 7, pour lequel ledit étage d'amplification (4a, 4b, 4c) est alimenté par une source de tension ou de courant externe audit équipement optoélectronique.

9. Système de commande selon la revendication 6 ou 7, pour lequel ledit étage d'amplification (4a, 4b, 4c,) est alimenté par une source de tension ou de courant interne audit équipement optoélectronique.

10. Système de commande selon l'une quelconque des revendications précédentes, pour lequel, le signal électromagnétique incident étant un signal modulé en impulsions donné, ledit détecteur-redresseur (3) est configuré pour avoir une constante de temps de décroissance du signal de détection supérieure à l'inverse d'une fréquence de répétition du signal électromagnétique incident en sorte de maintenir le signal de commande actif entre les répétitions dudit signal électromagnétique donné.

11. Système de commande selon l'une quelconque des revendications précédentes, pour lequel ledit détecteur-redresseur est constitué d'un détecteur RF à diode Schottky.

12. Ecran de blindage actif, pour hublot ou fenêtre de protection d'un équipement électronique, comportant une structure bidimensionnelle conductrice électriquement dans le domaine fréquentiel des hyperfréquences, en étant au moins partiellement transparente aux rayonnements optiques et comportant un dispositif d'activation/désactivation adapté à activer ledit blindage en reliant ladite structure à une masse électrique d'un support, **caractérisé en ce qu'**il comporte un système de commande selon l'une quelconque des revendications précédentes.

## Patentansprüche

1. Steuersystem zur Aktivierung/Deaktivierung einer Abschirmblende (11a, 11b, 11c, 11d) zur elektromagnetischen Abschirmung mit einer Aktivierungs-/Deaktivierungs-Vorrichtung (13, 14, 15, 16) für ein Sichtfenster oder Schutzfenster einer optoelektronischen Einrichtung,
**dadurch gekennzeichnet, dass** es einen elektromagnetischen Sensor zum Empfang eines elektromagnetischen Hochfrequenzfelds (1) mit einer Bandbreite umfasst, die auf einen einem Bereich der abzuschirmenden elektromagnetischen Felder entsprechenden Sperrbereich der Abschirmblende abgestimmt ist, wobei er mit einem Gleichrichter-Detektor (2) mit einer Empfindlichkeit verbunden ist, die über einem Mindestwert der Feldstärke eines elektromagnetischen Felds liegt, das mittels der elektromagnetischen Abschirmblende abgeschirmt werden soll, wobei der elektromagnetische Sensor und der Gleichrichter-Detektor dazu ausgelegt sind, bei Vorliegen eines elektromagnetischen Felds mit einer den Mindestwert überschreitenden Feldstärke die von dem elektromagnetischen Feld bereitgestellte elektromagnetische Energie zu erfassen, um die Vorrichtung (13, 14, 15, 16) zur Aktivierung/Deaktivierung der elektromagnetischen Abschirmblende mit der elektromagnetischen Energie zu versorgen und
zu aktivieren, die von dem elektromagnetischen Feld mit der den Mindestwert überschreitenden Feldstärke bereitgestellt wird.

2. Steuersystem nach Anspruch 1,
wobei die Aktivierungs-/Deaktivierungs-Vorrichtung eine PIN-Dioden-Vorrichtung (13, 14) ist, wobei der Gleichrichter-Detektor (2) die elektromagnetische Energie des vom Gleichrichter-Detektor (2) erfassten Signals in eine Spannung oder einen Strom zur Versorgung der PIN-Dioden-Vorrichtung umwandelt, die bzw. der zur Aktivierung der elektromagnetischen Abschirmblende erforderlich ist.

3. Steuersystem nach Anspruch 2,
wobei der elektromagnetische Hochfrequenzsensor eine Antenne (1) ist, die so dimensioniert ist, dass sie elektromagnetische Energie erfasst, mit der die Gleichrichter-Detektor-Vorrichtung direkt eine Spannung oder einen Strom zur Versorgung der Aktivierungs-/Deaktivierungs-Vorrichtung erzeugen kann, die bzw. der zur Aktivierung der Abschirmung erforderlich ist, wenn der Wert der abzuschirmenden elektromagnetischen Feldstärke einen Sollwert überschreitet.

4. Steuersystem nach Anspruch 2 oder 3,
wobei die Abschirmblende (11a) über ein Netzwerk, das mehrere parallele Anschlüsse aufweist, mit einer Sammelstruktur (12) verbunden ist, wobei jeder Anschluss einen Kondensator (132) und eine PIN-Diode (13) in Reihe enthält, wobei der Gleichrichter-Detektor (2) bei Vorliegen eines elektromagnetischen Felds mit einer den Mindestwert überschreitenden Feldstärke eine Gleichspannungsquelle zur elektrischen Vorspannung der PIN-Dioden bildet, die über Widerstände (131) an die Anoden der PIN-Dioden (13) angeschlossen ist, wobei die Kathoden der PIN-Dioden an die Sammelstruktur angeschlossen sind.

5. Steuersystem nach Anspruch 4,
wobei die Sammelstruktur (12) eine elektrisch leitende Einfassung der Abschirmung ist, die an eine Masse der Einrichtung angeschlossen ist.

6. Steuersystem nach Anspruch 1,
wobei die Aktivierungs-/Deaktivierungs-Vorrichtung eine PIN-Dioden-Vorrichtung zwischen der Abschirmblende und einem Rahmen (12) der Abschirmblende oder ein Leiterbahnnetz aus Materialien mit Isolator/Metall-Übergang, beispielsweise VO₂ (15), oder ein Pumpsystem (16) zum Einspritzen einer Flüssigkeit mit hoher dielektrischer Permittivität und/oder elektrischer Leitfähigkeit innerhalb eines umlaufenden Kanals (19) zwischen der Struktur der elektromagnetischen Abschirmblende (11d) und ihrer an die Masse angeschlossenen Einfassung ist und eine Verstärkerstufe (4a, 4b, 4c) umfasst, die zwischen der Gleichrichter-Detektor-Vorrichtung und der PIN-Dioden-Vorrichtung, dem Leiterbahnnetz aus Materialien mit Isolator/Metall-Übergang oder dem Pumpsystem (16) der elektromagnetischen Abschirmblende angeordnet ist.

7. Steuersystem nach Anspruch 6,
wobei ein Komparator (3b) am Ausgang des Gleichrichter-Detektors den Verstärker ansteuert.

8. Steuersystem nach Anspruch 6 oder 7,
wobei die Verstärkerstufe (4a, 4b, 4c) von einer Spannungs- oder Stromquelle versorgt wird, die außerhalb der optoelektronischen Einrichtung liegt.

9. Steuersystem nach Anspruch 6 oder 7,
wobei die Verstärkerstufe (4a, 4b, 4c) von einer Spannungs- oder Stromquelle versorgt wird, die innerhalb der optoelektronischen Einrichtung liegt.

10. Steuersystem nach einem der vorstehenden Ansprüche,
wobei das ankommende elektromagnetische Signal ein gegebenes pulsmoduliertes Signal ist und der Gleichrichter-Detektor (3) so ausgelegt ist, dass er eine Abklingzeitkonstante des Detektionssignals aufweist, die höher ist als der Kehrwert einer Wiederholungsfrequenz des ankommenden elektromagnetischen Signals, um das Steuersignal zwischen den Wiederholungen des gegebenen elektromagnetischen Signals aktiv zu halten.

11. Steuersystem nach einem der vorstehenden Ansprüche, wobei der Gleichrichter-Detektor aus einem HF-Detektor mit Schottky-Diode besteht.

12. Aktive Abschirmblende für ein Sichtfenster oder ein Schutzfenster einer elektronischen Einrichtung, mit einer zweidimensionalen Struktur, die im Ultrahochfrequenzbereich elektrisch leitfähig ist, indem sie für optische Strahlung zumindest teilweise transparent ist, und mit einer Aktivierungs-/Deaktivierungs-Vorrichtung, die dazu ausgelegt ist, die Abschirmung zu aktivieren, indem sie die Struktur mit einer elektrischen Masse eines Trägers verbindet,
**dadurch gekennzeichnet, dass** sie ein Steuersystem nach einem der vorstehenden Ansprüche umfasst.

## Claims

1. System for controlling the activation/deactivation of an electromagnetic shielding screen (11a, 11b, 11c, 11d) provided with an activation/deactivation device (13, 14, 15, 16) for a porthole or a protective window of an optoelectronic equipment, **characterised in that** it includes an electromagnetic sensor for receiving a radiofrequency electromagnetic field (1), with a bandwidth adapted to a cut-off band of said shielding screen corresponding to a range of electromagnetic fields to be blocked, connected to a detector-rectifier (2) with a sensitivity higher than a minimum value of the power of an electromagnetic field to be blocked by means of said electromagnetic shielding screen, said electromagnetic sensor and detector-rectifier being configured, in the presence of the electromagnetic field with a power exceeding said minimum value, to capture electromagnetic energy provided by said electromagnetic field power to supply and to activate said device (13, 14, 15, 16) for activating/deactivating the electromagnetic shielding screen with the electromagnetic energy supplied by said electromagnetic field with a power exceeding said minimum value.

2. Control system according to claim 1, wherein, the activation/deactivation device being a PIN diode device (13, 14), said detector-rectifier (2) converts the electromagnetic energy of the signal captured by said detector-rectifier (2) in a supply voltage or current of the PIN diode device necessary to activate said electromagnetic shielding screen.

3. Control system according to claim 2, wherein the radiofrequency electromagnetic sensor is an antenna (1) sized to sense an electromagnetic energy adapted to enable said detector-rectifier device to directly produce a supply voltage or current of said activation/deactivation device necessary to activate said shielding for an electromagnetic field power value to be blocked higher than a setpoint value.

4. Control system according to claim 2 or 3, wherein the shielding screen (11a) is connected to a collector structure (12) throughout a network including a plurality of parallel links, each link including a capacitor (132) and a PIN diode (13) in series, the detector-rectifier (2) making, in the presence of said electromagnetic field with a power exceeding said minimum value, a direct voltage source for electrically polarising said PIN diodes connected to the anodes PIN diodes (13) throughout resistors (131), the cathodes of said PIN diodes being connected to the collector structure.

5. The control system according to claim 4, wherein the collector structure (12) is an electrically-conductive frame of the shield connected to a ground of said equipment.

6. Control system according to claim 1, wherein the activation/deactivation device is a PIN diode device between the shielding screen and a frame (12) of the shielding screen or an array with insulator/metal transition material tracks, for example VO₂ (15) or a pump system (16) for injecting a liquid with high dielectric permittivity and/or electrically conductive within a peripheral channel (19) between the structure of the electromagnetic shielding screen (11d) and its frame connected to the ground, and includes an amplification stage (4a, 4b, 4c) interposed between the detector/rectifier device and the said PIN diode device, said array with insulator/metal transition material tracks or said pump system (16) of said electromagnetic shielding screen.

7. Control system according to claim 6, wherein a comparator (3b) at the output of the detector-rectifier drives said amplifier.

8. Control system according to claim 6 or 7, wherein said amplification stage (4a, 4b, 4c) is powered by a voltage or current source external to said optoelectronic equipment.

9. Control system according to claim 6 or 7, wherein said amplification stage (4a, 4b, 4c,) is powered by a voltage or current source internal to said optoelectronic equipment.

10. Control system according to any one of the preceding claims, wherein, the incident electromagnetic signal being a given pulse-modulated signal, said detector-rectifier (3) is configured to have a decay time constant of the detection signal higher than the inverse of a repetition frequency of the incident electromagnetic signal so as to keep the control signal active between the repetitions of said given electromagnetic signal.

11. Control system according to any one of the preceding claims, wherein said detector-rectifier consists of a Schottky diode RF detector.

12. An active shielding screen, for a porthole or a protective window of electronic equipment, including an electrically-conductive two-dimensional structure in the microwave frequency domain, being at least partially transparent to optical radiation and including an activation/deactivation device adapted to activate said shielding by connecting said structure to an electrical ground of a support, **characterised in that** it includes a control system according to any one of the preceding claims.
